## Europäisches Patentamt

## European Patent Office

## Office européen des brevets

(11) Veröffentlichungsnummer: **0 131 641**
**B1**

(12) # EUROPÄISCHE PATENTSCHRIFT

(45) Veröffentlichungstag der Patentschrift:
12.10.88

(51) Int. Cl.⁴: **H 04 B 1/66**

(21) Anmeldenummer: **83106915.8**

(22) Anmeldetag: **14.07.83**

(54) **Verfahren zur Anpassung von zwei Systemen mit unterschiedlicher Abtastrate.**

(43) Veröffentlichungstag der Anmeldung:
**23.01.85 Patentblatt 85/4**

(45) Bekanntmachung des Hinweises auf die Patenterteilung:
**12.10.88 Patentblatt 88/41**

(84) Benannte Vertragsstaaten:
**AT CH DE FR GB LI**

(56) Entgegenhaltungen:
**PROCEEDINGS OF THE IEEE, Band 69, Nr. 3, März 1981, Seiten 300-331, New York, USA, R.E. CROCHIERE et al.: "Interpolation and decimation of digital signals - A tutorial review"**
**1981 IEEE INTERNATIONAL SYMPOSIUM ON CIRCUITS AND SYSTEMS PROCEEDINGS, Band 2, Chicago, Illinois (USA), 27.-29. April 1981, Seiten 447-450, IEEE, New York, USA, R. ANSARI et al.: "Interpolators and decimators as periodically time-varying filters"**
**1982 IEEE INTERNATIONAL SYMPOSIUM ON CIRCUITS AND SYSTEMS, vol. 2, Rome, 10.-12. Mai 1982, Seiten 260-263, IEEE, New York, USA, A.G. CONSTANTINIDES et al.: "A class of efficient interpolators and decimators with applications in transmultiplexing"**

(73) Patentinhaber: **ANT Nachrichtentechnik GmbH, Gerberstrasse 33, D-7150 Backnang (DE)**

(72) Erfinder: **Göckler, Heinz, Dipl.- Ing., Elbinger Strasse 52, D-7150 Backnang (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein Verfahren zur Anpassung von zwei Systemen mit unterschiedlichen Abtastraten gemäß Oberbegriff des Anspruchs 1.

Solche Verfahren sind bekannt, beispielsweise durch den Aufsatz "A 2-channel 16-bit digital sampling frequency converter for professional digitalaudio" von Lagadec, Pelloni und Weiß in ICASSP-82 (International Conference Accoustics Speech and Signal Processing, Paris, Seite 93 bis 96), wobei eine stufenweise Erhöhung der Abtastrate auf das $2^{15}$-fache mit nachfolgender Verminderung vorgesehen ist. Nachteilig ist hierbei die sehr hohe Verarbeitungsrate.

Der vorliegenden Erfindung lag deshalb die Aufgabe zugrunde, ein unaufwendiges Verfahren zur Anpassung der Abtastrate anzugeben, das mit einer Signalverarbeitungsrate auskommt, die nicht höher als die höchste der beiden Abtastraten ist. Gleichzeitig soll das Verfahren unaufwendig sein und die Anpassung von Systemen mit beliebigem Abtastratenverhältnis ermöglichen.

Die Lösung erfolgt mit den im Patentanspruch 1 angegebenen Mitteln. ·

Das erfindungsgemäße Verfahren ermöglicht die Anpassung von Abtastraten, die in einem beliebigen Verhältnis stehen, wobei die interne Signalverarbeitung mit einer Rate erfolgen kann, die deutlich unter der kleinsten Abtastrate liegen kann. Die Unteransprüche bieten weitere vorteilhafte Weiterbildungen.

In vielen Fällen weisen die Abtastraten jeweils Toleranzbreiten auf, hier ist es günstig, jeweils die arithmetischen Mittel $\bar{f}i$, $\bar{f}o$ der Toleranzbereiche festzustellen, um dann L und M so zu wählen, daß $\bar{f}i.M = \bar{f}o.L$ ist. Das Verhältnis der beiden Abtastraten bzw. der arithmetischen Mittenfrequenzen kann dabei auch nicht ganzzahlig oder gleich dem Kehrwert einer ganzen Zahl sein.

Selbstverständlich bleibt die Erfindung nicht auf die Verarbeitung oder Übertragung zeitdiskreter Signale (zeitdisret: für jeden Zeitschlitz definierter Länge (Zeitquant) wird jeweils ein diskreter (analoger) Signalwert angenommen, der beispielsweise dem Mittelwert des Signal(amplituden)verlaufs in dem Zeitabschnitt entspricht) beschränkt, sondern kann auch auf digitale (digital: die Signalwerte sind gequantelt) Signale ausgedehnt werden.

Es folgt nun eine Beschreibung der Erfindung anhand der Figuren.

Die Fig. 1 zeigt eine Kaskadenschaltung eines Ganzzahlinterpolators und eines Ganzzahldezimators zur Abtastratenkonvertierung bei rationalen Verhältnissen.

Die Fig. 2 stellt ein Kommutatormodell für einen M : 1-Polyphasendezimator dar.

Die Fig. 3 schließlich zeigt eine Anordnung zur Durchführung des erfindungsgemäßen Verfahrens.

In Fig. 4 ist die Realisierung eines Filterzweiges nach Fig. 3 dargestellt.

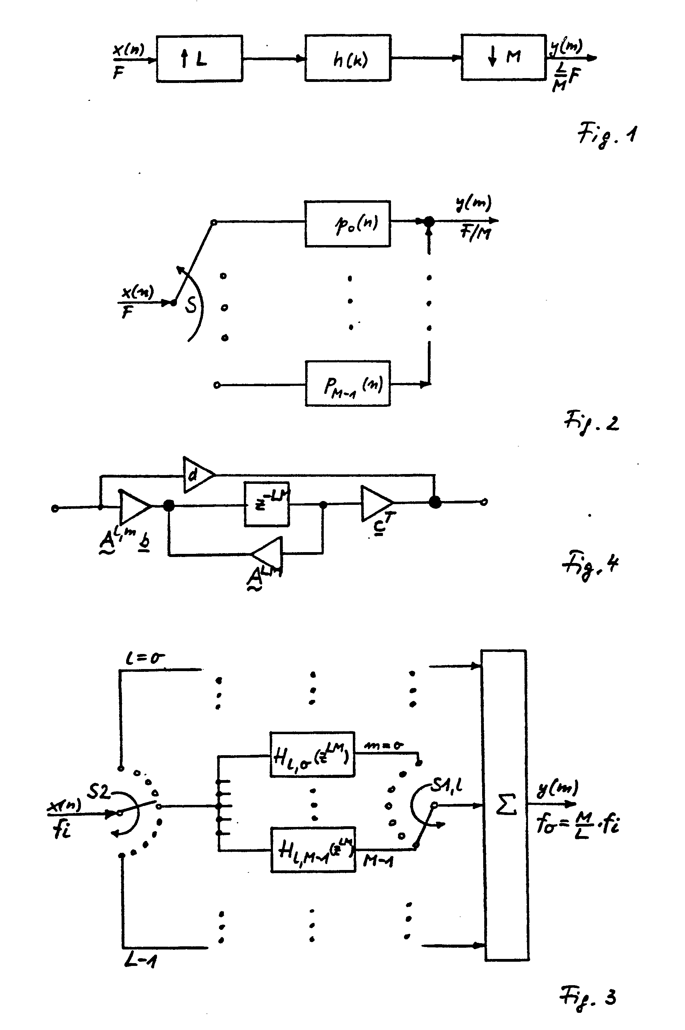

Die Figuren 1 und 2 stellen den Stand der Technik dar, wie er sich aus dem Aufsatz "Interpolation and Decimation of Digital Signals - a Tutorial Review" von Crochiere und Rabiner, in Proceedings of IEEE, Vol. 69, No. 3, March 1981, S. 300 bis 321 darstellt.

In Fig. 1 wird das Eingangssignal x(n) mit der Abtastrate F mit dem ganzzahligen Vielfachen L abgetastet, anschließend durch die Filterfunktion h(k) gefiltert und zuletzt mit der um den Faktor H erniedrigten Abtastrate abgetastet, so daß ein Ausgangssignal y(m) entsteht, welches die Abtastrate F . L/M aufweist.

Die Fig. 2 stellt ein Kommutatormodell für einen M : 1-Polyphasen-Dezimator dar, wobei die Eingangsfunktion x(n) mit der Abtastrate F mittels rotierendem Schalter S auf M Filterpfade $p_0(n)$ bis $p_{M-1}(n)$ verteilt wird und wobei anschließend die Filterausgangssignale zum Ausgangssignal y(m) zusammengefaßt wird, welches nunmehr die reduzierte Abtastrate $\frac{1}{M}$ F aufweist. Betreibt man den Dezimator nach Fig. 2 transponiert, d. h. in Rückrichtung, wobei alle Richtungspfeile zu invertieren und alle Summationspunkte durch Verzweigungspunkte zu ersetzen sind, so ergibt sich dadurch ein Abtastrateninterpolator, durch den die Abtastrate um den ganzzahligen Faktor M erhöht wird.

In Figur 3 ist eine Schaltungsanordnung zur Durchführung des erfindungsgemäßen Verfahrens gezeichnet, wobei das Eingangssignal x(m) mit der Abtastrate fi mittels eines Verteilermultiplexers S2 auf L Filterpfade verteilt wird. Jeder dieser L Pfade enthält seinerseits wiederum M parallel geschaltete Filter $H_2O$ ($z^{LM}$) bis $H_{I,M-1}$ ($z^{LM}$) mit I = 0 bis L-1. Die Ausgänge der M Filterzweige eines jeden Pfades werden mittels eines weiteren Multiplexerschalters S1,I der also insgesamt L-fach vorhanden ist, zyklisch abgetastet und mittels eines Summergliedes Σ zum Ausgangssignal y(m), welches die Abtastrate fo = fi · M/L aufweist, zusammengefaßt.

Die Erfindung geht dabei von der Idee aus, bei einem Abtastratendezimator gemäß Fig. 2 die einzelnen Filterzweige pi(n) durch einen transponiert betriebenen Dezimator, d. h. einen Abtastrateninterpolator, zu ersetzen, wodurch die Abtastratenanpassung im Verhältnis M zu L ermöglicht wird. Durch diese Substitution wird gleichzeitig ermöglicht, daß alle Filteroperationen mit der niedrigsten auftretenden Abtastrate nämlich fi/L = fo/M durchgeführt werden können. Die verschiedenen Filterzweige dieses dezimierenden/interpolierenden Polyphasen-Netzwerkes sind beispielsweise realisierbar durch die Zustandsvariablen-Filterstruktur gemäß Fig. 4.

Die Schaltungsanordnung nach Fig. 3 und die Realisierung der einzelnen Filterzweige gemäß Fig. 4 sind Ausführungsbeispiele, das erfindungsgemäße Verfahren ist jedoch nicht darauf beschränkt.

Besondere Vorteile werden in der stärkeren Parallelisierung und damit in der verminderten Operationsrate gesehen, wobei bei beliebigen Werten von L und M keine höheren Abtastraten als fi/L = fo/M auftreten, wogegen lediglich mehr Parallelzweige entsprechend den Werten L und M zu verarbeiten sind.

Besonders vorteilhaft ist auch, daß die beiden anzupassenden Systeme asynchronen oder synchronen Betrieb aufweisen können, d. h. fo/fi näherungsweise gleich M/L.

In vielen Fällen ist es günstig, die Schaltungsanordnungen, beispielsweise gemäß Fig. 3, transponiert, d. h. in entsprechend übersetzter, (richtungs)umgekehrter Weise zu betreiben, wobei ein Summierglied durch eine Verzweigung und umgekehrt ersetzt wird.

## Patentansprüche

1. Verfahren zur Anpassung von zwei Systemen zur Übertragung oder Verarbeitung von zeitdiskreten Signalen mit den unterschiedlichen Abtastraten fi des Quellensystems und fo des Senkensystems, wobei das Quellensignal mit seiner Abtastrate fi auf L Filterpfade zyklisch verteilt, dort gefiltert und anschließend zusammengefaßt wird, <u>dadurch gekennzeichnet</u> daß in den L Filterpfaden jeweils die Filterung in M eingangsseitig parallel geschalteten Filterzweigen ($H_{l,m}$ ($z^{LM}$)) mit der Verarbeitungsraten fi/L und mit anschließendem Halten erfolgt und die Ausgangssignale der M Filterzweige zyklisch mit der Abtastrate fo = fi . M/L des Senkensystems abgetastet werden.

2. Verfahren nach Anspruch 1, wobei die Abtastraten jeweils eine Toleranzbreite aufweisen, <u>dadurch gekennzeichnet,</u> daß jeweils die arithmetische Mitte $\overline{fi}$, $\overline{fo}$ des Toleranzbereiches festgestellt wird und daß L und M so gewählt werden, daß $\overline{fi}$ . M = $\overline{fo}$ . L ist.

3. Verfahren nach Anspruch 1 oder 2, <u>dadurch gekennzeichnet,</u> daß die beiden Abtastraten bzw. die arithmetischen Mittenfrequenzen der Toleranzbereiche in einem Verhältnis zueinander stehen, das nicht ganzzahlig oder der Kehrwert einer ganzen Zahl ist.

4. Verfahren nach einem der vorhergehenden Ansprüche, <u>dadurch gekennzeichnet,</u> daß die beiden Systeme asynchron sind.

5. Verfahren nach einem der Ansprüche 1 bis 3, <u>dadurch gekennzeichnet,</u> daß die beiden Systeme synchron betrieben werden.

6. Verfahren nach einem der vorhergehenden Ansprüche, <u>dadurch gekennzeichnet,</u> daß das zu übertragende oder zu verarbeitende Signal digital ist.

7. Schaltungsanordnung zur Durchführung eines Verfahrens zur Anpassung von zwei Systemen zur Übertragung oder Verarbeitung von zeitdiskreten Signalen mit unterschiedlichen Abtastraten (fi, fo) nach Anspruch 1, wobei ein Multiplexerschalter (S2) zur Verteilung des Eingangssignals (x(n)) auf L Pfade vorgesehen ist, <u>dadurch gekennzeichnet,</u> daß in den L Filterpfaden jeweils M eingangsseitig parallel geschaltete Filterzweige ($H_{l,m}$ ($z^{LM}$)) mit der Verarbeitungsrate fi/L vorgesehen sind, daß zur Abtastung der M Filterzweige eines jeden der L Pfade jeweils ein Multiplexerschalter (S1, l) und daß zur Aufsummierung der so abgetasteten Ausgangssignale (y(m)) der Filterzweige ein Summierglied ($\Sigma$) vorgesehen sind.

8. Schaltungsanordnung nach Anspruch 7, <u>gekennzeichnet durch</u> die Verwendung in transponierter Betriebsweise, wobei das Summierglied durch eine Verzweigung ersetzt wird.

## Claims

1. Method of adapting two systems for the transmission or processing of time discrete signals at different sampling rates fi for the source system and fo for the sink system, with the source signal being cyclically distributed at its sampling rate fi to L filter paths, being filtered there and then combined, <u>characterised in that,</u> in the L filter paths, filtering and subsequent holding takes place in M filter branches ($H_{l,m}(z^{LM})$) whose inputs are connected in parallel, the filtering taking place at the processing rate fi/L and the output signals of the M filter branches are cyclically sampled at the sampling rate fo = fi · M/L of the sink system.

2. Method according to claim 1, wherein the sampling rates each have a tolerance range, <u>characterised in that</u> the arithmetic means $\overline{fi}$, $\overline{fo}$ of the tolerance range is determined and L and M are selected in such a manner that $\overline{fi}$ · M = $\overline{fo}$ · L.

3. Method according to claim 1 or 2, <u>characterised in that</u> the two sampling rates and the arithmetic mean frequencies of the tolerance ranges are at a ratio to one another which is not a whole number or is the reciprocal of a whole number.

4. Method according to one of the preceding claims, <u>characterised in that</u> the two systems are asynchronous.

5. Method according to one of claims 1 to 3, <u>characterised in that</u> the two systems are operated in synchronism.

6. Method according to one of the preceding claims, <u>characterized in that</u> the signal to be transmitted or processed is a digital signal.

7. Circuit arrangement for implementing a method of adapting two systems for the transmission or processing of time discrete signals at different sampling rates (fi, fo) according to claim 1, wherein a multiplexer switch (S2) is provided to distribute the input signal (x,(n)) to L paths, <u>characterised in that,</u> in each of the L filter paths, there are provided M

filter branches ($H_{l,m}(z^{LM})$) whose inputs are connected in parallel and which operate at a processing rate fi/L; a multiplexer switch (S1, l) is provided to sample the M filter branches in each one of the L paths; and a summing member ($\Sigma$) is provided to sum up the thus sampled output signals (y(m)) of the filter branches.

8. Circuit arrangement according to claim 7, <u>characterized in that</u> it is used in a transposed mode of operation, with the summing member being replaced by a branching arrangement.

**Revendications**

1. Procédé pour l'adaptation de deux systèmes servant à la transmission ou au traitement de signaux discrets dans le temps, dans lequel le système source présente une vitesse d'échantillonnage fi qui diffère de la vitesse d'échantillonnage fo du système collecteur, dans lequel le signal de source est réparti cycliquement avec sa vitesse d'échantillonnage fi sur L voies de filtrage, filtré dans ces voies et réuni ensuite, caractérisé en ce que, dans chacune des voies de filtrage L, le filtrage s'opère dans M branches de filtrage connectées en parallèle côté entrée ($H_{l,m}(z^{LM})$) avec la vitesse de traitement fi/L et avec maintien consécutif et que les signaux de sortie des M branches de filtrage sont échantillonnés cycliquement avec la vitesse d'échantillonnage fo = fi · M/L du système collecteur.

2. Procédé selon la revendication 1, dans lequel les vitesses d'échantillonnage présentent chaque fois une marge de tolérances, caractérisé en ce que la moyenne arithmétique $\bar{f}i$, $\bar{f}o$ de la plage de tolérances est déterminée chaque fois et que L et M sont choisis de manière que $\bar{f}i \cdot M = \bar{f}o \cdot L$.

3. Procédé selon la revendication 1 ou 2, caractérisé en ce que les deux vitesses d'échantillonnage ou les fréquences arithmétiques moyennes des plages de tolérances présentent un rapport mutuel qui ne correspond pas à un nombre entier ou à l'inverse d'un entier.

4. Procédé selon une des revendications précédentes, caractérisé en ce que les deux systèmes sont asynchrones.

5. Procédé selon une des revendications 1 à 3, caractérisé en ce que les deux systèmes sont utilisés en synchronisme.

6. Procédé selon une des revendications précédentes, caractérisé en ce que le signal à transmettre ou à traiter est un signal numérique.

7. Montage pour la mise en oeuvre d'un procédé pour l'adaptation de deux systèmes servant à la transmission ou au traitement de signaux discrets dans le temps et présentant des vitesses d'échantillonnage différentes (fi, fo), selon la revendication 1, avec prévision d'un commutateur multiplexeur (S2) pour la répartition du signal d'entrée (x(n)) sur L voies, caractérisé en ce que, dans les L voies de filtrage, on a prévu chaque fois M branches de filtrage ($H_{l,m}(z^{LM})$) connectées en parallèle côté entrée, avec la vitesse de traitement fi/L, qu'un commutateur multiplexeur (S1, l) est prévu pour l'échantillonnage des M branches de filtrage de chacune des L voies et que, pour la totalisation des signaux de sortie (y(m)) ainsi échantillonnés des branches de filtrage, on a prévu un totalisateur ($\Sigma$).

8. Montage selon la revendication 7, caractérisé par l'utilisation en mode de fonctionnement transposé, avec remplacement du totalisateur par une ramification.

Fig. 1

Fig. 2

Fig. 4

Fig. 3